Europäisches Patentamt

European Patent Office

Office européen des brevets

(19)

(11) Veröffentlichungsnummer: **0 002 668
B1**

(12) **EUROPÄISCHE PATENTSCHRIFT**

(45) Veröffentlichungstag der Patentschrift: 28.04.82

(21) Anmeldenummer: 78101459.2

(22) Anmeldetag: 27.11.78

(51) Int. Cl.³: **G 01 B 11/27, G 05 D 3/12, G 03 B 41/00**

(54) Einrichtung zur optischen Abstandsmessung.

(30) Priorität: 30.12.77 US 865807

(43) Veröffentlichungstag der Anmeldung:
11.07.79 Patentblatt 79/14

(45) Bekanntmachung des Hinweises auf die Patenterteilung:
28.04.82 Patentblatt 82/17

(84) Benannte Vertragsstaaten:
DE FR GB

(56) Entgegenhaltungen:
NL - A - 76 06548
US - A - 3 507 597
US - A - 3 883 249
US - A - 4 037 969

(73) Patentinhaber: International Business Machines
Corporation
Armonk, N.Y. 10504 (US)

(72) Erfinder: Charsky, Ronald Stephen
24 Overbrook Avenue
Binghamton New York 13903 (US)
Erfinder: Flamholz, Alexander Leon
32 Dolson Road
Monsey New York 10952 (US)

(74) Vertreter: Teufel, Fritz, Dipl.-Phys.
Schönaicher Strasse 220
D-7030 Böblingen (DE)

Courier Press, Leamington Spa, England.

Einrichtung zur optischen Abstandsmessung

Die Erfindung betrifft eine Einrichtung zur optischen Abstandsmessung nach dem Oberbegriff von Anspruch 1.

Bei vielen modernen Herstellungsverfahren ist es erforderlich, den lateralen Abstand zwischen zwei Gegenständen oder zwischen zwei Punkten eines Gegenstands automatisch und mit großer Genauigkeit zu messen, wenn sich die Gegenstände in verschiedenen Ebenen befinden und nicht in die gleichen oder in benachbarte Ebenen gebracht werden können. Beispeilsweise ist es bei der Herstellung integrierter Schaltkreise notwendig, die Muster einer Projektionsbelichtungsmaske genau mit den schon vorhandenen Mustern einer auf einer Halbleiterscheibe aufgebrachten photoempfindlichen Schicht auszurichten, so daß beide bei der Belichtung genau übereinanderliegen. Außerdem ist es erforderlich, Sätze von Belichtungsmasken vor deren Verwendung zu überprüfen, um demit sicherzustellen, daß die Muster verschiedener Masken innerhalb zulässiger Toleranzgrenzen übereinstimmen.

Die Dichte der Elemente in integrierten Schaltkreisen wird laufend erhöht, damit mehr Schaltkreise auf einem Halbleitergebiet vorgegebener Größe erzeugt werden können. Dadurch steigen auch die Anforderungen an die Ausrichtung und an die Messung der immer kleiner werdenden Dimensionen Im Fall des Ausrichtens von Maske und Halbleiterscheibe bei der Projektionsbelichtung ist es üblich, einander entsprechende Richtmarken auf der Maske und er Halbleiterscheibe anzubringen. Bischer wurden diese Marken manuell in Übereinstimmung gebracht. Dieses Verfahren ist langsam, außerdem wird die Ausrichtung durch Ermüdung und Fehler des Bedieners beeintächtigt. Es wurden auch schon elektrooptische Ausrichtsysteme entwickelt, bei denen die Ausrichtung automatisch erfolgen kann, doch haben diese Einrichtungen die manuelle Ausrichtung noch nicht ersetzt. Ein Grund dafür liegt in der Qualität der Marke und der Anzahl der Materialschichten, die über der Marke liegen können; die dann zur Verfügung stehenden Ausrichtsignale erlauben es nicht, immer die für eine Produktionslinie erforderliche Verläßlichkeit bei der Ausrichtung zu erzielen.

Aus der deutschen Offenlegungsschrift 26 51 430 ist ein derartiges automatisches Ausrichtsystem bekannt, bei dem das Ausrichtsignal durch Modulation eines Phasenrasters erzeugt wird; obwohl für Ausrichtung und die Projektion dasselbe optische System verwendet werden, bedingt die vorgeschlagene Modulation einen Beträchtlichen apparativen Aufwand.

Die US- Patentschrift 3 957 376 beschreibt ein Meßberfahren für die charakteristischen Abmessungen von Kantenlinien oder Begrenzungslinien von Musters auf einer Halbleiterscheibe, bei dem ein Beugungsmuster zweier paralleler physikalischer Kanten verwendet wird, die in derselben oder fast derselben Ebene liegen.

Wenn bei der Messung zwei Gegenstände beteiligt sind, ist es nich immer möglich, die Kanten in dieselbe Ebene zu legen. Die US-Patentschriften 3 797 939, 3 883 249 und 3 884 581 beschreiben, wie Lagen von Begrenzungslinien durch Analyse der Interferenzmuster bestimmt werden, wobei die Begrenzungslinien auch in verschiedenen Ebenen längs des Lichtpfades liegen können und die Interferenzwellen durch die pysikalischen Begrenzungslinien erzeugt sind. Im Fall der Ausrichtung von Maske und Halbleiterscheibe liegt eine der Begrenzungslinien auf einer lichtundurchlässigen Oberfläche, so daß auf der im Stand der Technik bekannten Weise kein verwertbares Interferenzmuster erzeugt werden kann.

Die Verwendung von Interferenzmustern zur optischen Ausrichtung ist im Stand der Technik auch auf anderen Gebieten bekannt; beispielsweise wird in der US-Patentschrift 3 507 597 vorgeschlagen, bei der Ausrichtung einer Linse zur optischen Achse das Interferenzmuster auszuwerten, das bei der Überlagerung von an Vorder- und Rückseite der Linse reflektiertem Laserlicht entsteht. Dieses Meßverfahren läßt sich jedoch nicht zur Auswertung von Kantenabständen verwenden.

Die vorliegende Erfindung stellt sich daher die Aufgabe, mit optischen Mitteln der lateralen Abstand zweier in verschiedenen Ebenen liegenden linienhafter Elemente, z. B. Kanten, sehr genau zu messen und hierfür eine Einrichtung anzugeben, die insbesondere auch anwendbar ist wenn sich eine der Kanten auf einem undurchsichtigen Substrat befindet.

Die Aufgabe wird durch die im Hauptanspruch gekennzeichnete Erfindung gelöst; Ausgestaltungen duer Erfindung sind in den Unteransprüchen gekennzeichnet.

In einem Ausführungsbeispiel der Erfindung werden zwei zu verschiedenen Gegenständen gehörige Kanten mit kollimierter, monochromatischer, räumlich kohärenter Strahlung beleuchtet und eine Bild der ersten Kante in einer Ebene eiener zweiten Kante erzeugt; dadurch wird ein Beugungsmuster infolge Interferenz des Lichtes von der zweiten Kante und vom Bild der ersten Kante hervorgerufen. Das Beugungsbild wird auf einen Sensor gegeben, der die Lichtstärke an verschiedenen Punkten des Musters feststellt, so daß die Lage der Beugungsminima ermittelt werden kann. Aus dem Abstand der Beugungsminima wird der laterale Abstand der Kanten bestimmt.

Diese Meßeinrichtung wird weiterhin zur gegenseitigen Ausrichtung zweier Gegenstände verwendet. Dazu werden auf beiden Gegenständen Richtmarken mit einem (in ausgerichteter Lage) lateralen Abstand verwendet; beispielswise wird für die X- und die dazu orthogonale Y-Richtung je eine Richtmarke vorgesehen. Mit Hilfe kollimierter, monochromatischer, räumlich kohärenter Strahlung wird das Bild der Richtmarken des einen Gegenstands in der Ebene der Richtmarken des zweiten Gegenstands erzeugt und das entstehende Interferenzmuster mit einem Sensor ausgewertet. Der ermittelte Abstand dient als Stellsignal zur Verschiebung in X- und Y-Richtung und zur Winkelausrichtung.

Das auf diese Weise erzeugte Beugungsmuster liefert eine Genauigkeit, die mit derjenigen vergleichbar ist, wenn zwei in derselben Ebene physikalisch vorhandene Kanten untersucht werden. Die erreichbare Genauigkeit liegt in der Größenordnung von 0,025 $\mu$m. Das Signal-Rausch-Verhältnis ist groß und liefert nutzbare Signale, auch wenn Richtmarken mit geringem Kontrast verwendet werden und/oder wenn die Richtmarken durch darüberliegende Schichten bedeckt sind.

Ein Ausführungsbeispiel der Erfindung wird nun anhand von Zeichnungen näher erläutert.

Es zeigen:

Fig. 1 die schematische Darstellung einer Ausführungsform der Erfindung,

Fig. 2 ein Beugungsmuster, wie es auf einer Oszillographenröhre bei Verwendung des in Fig. 1 dargestellten Systems dargestellt wird,

Fig. 3 eine schematische Darstellung eines gesamten Systems zur Ausrichtung von Belichtungsmasken und Halbleiterscheiben bei der Belichtung des Photolacks,

Fign. 4a und 4b ein Beispiel geeigneter, korrespondierender Muster für Richtmarken auf Maske und Halbleiterscheibe,

Fign. 5a bis 5c die Lage von Richtmarken zur Messung der relativen Lagen von Maske und Halbleiterscheibe beim Ausrichtverfahren.

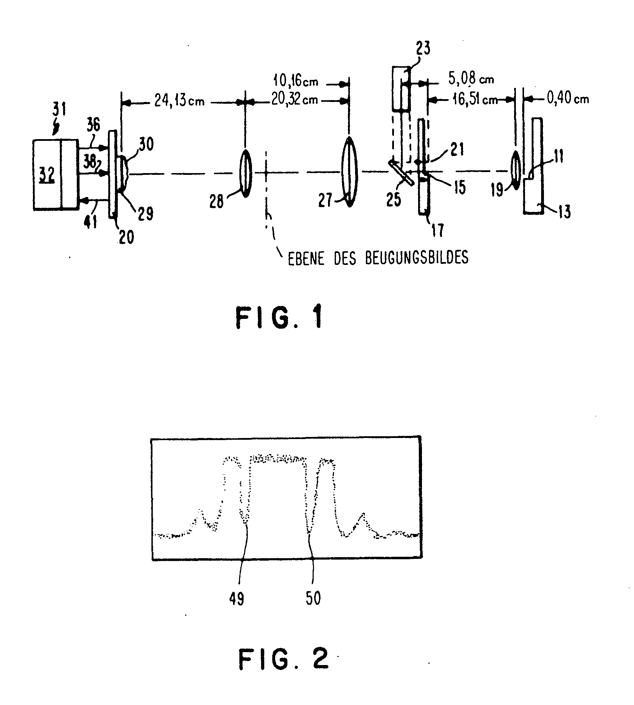

Fig. 1 zeigt ein Meßsytem für den lateralen Abstand zwischen einer Kante 11 eines ersten undurchsichtigen Gegenstands 13, beispielsweise einer Halbleiterscheibe, und einer Kante 15 eines zweiten Gegenstands 17, beispielsweise einer Glasmaske mit Chrommuster in schematischer Darstellung; zur Veranschaulichung sind die Abmessungen der Kanten übertrieben. Die Gegenstände 13 und 17 befinden sich in verschiedenen Ebenen, die parallel zur Projektionslinse 19 liegen (beispielsweise einer 32x/0,60 Leitzlinse), die in der Ebene des Gegenstandes 17 ein Bild 21 der Kante 11 erzeugt, wenn die Kanten durch eine Lichtquelle 23 mit kollimiertem, monochromatischem, räumlich kohärentem Licht beleuchtet werden; als Lichtquelle kann beispielsweise ein Helium-Neonlaser (Leistung 5 mw) dienen, der über Strahlteiler 25 auf die Kanten gerichtet ist. Die Kanten 11 und 15 stellen Linien dar, die "im wesentlichen parallel" sind; darunter können Kanten einer Linie, die Kanten eines Quadrats oder eines Rechtecks oder die parallelen Tangentenstücke eines Kreises oder einer Ellipse verstanden werden. Die Linsen 27 (beispielsweise NIKKOR-P mit f=105 mm) und 28 (beispielsweise Leitz 3,2x/0,12) bilden das Beugungsmuster 30, das durch Interferenz zwischen dem an Kante 15 gebeugten Licht und dem Licht des Bildes 21 von Kante 11 entsteht, auf einen Sensor 20 mit einer Diodenmatrix 29 ab; ein geeigneter Sensor ist beispielsweise das mit Festkörper-Linien-Abtastschaltungen versehene Modell RL-256DA der Reticon Corporation, bei dem 256 Siliciumphotodioden mit einem Abstand von 25 $\mu$m angeordnet sind. Struktur und Wirkungsweise der Reticonabtasters ist in der US- Patentschrift 3 957 376 beschrieben, auf die hier verwiesen wird.

Fig. 2 zeigt eine Zeichnung mit dem Beugungsmuster, wie man es auf einem Oszillographenschirm mit Hilfe des in Fig. 1 dargestellten Systems erzeugt. Eine Rechen- und Steuervorrichtung 31 liefert über Leitung 38 ein Startsignal und über Leitung 36 Taktsignale; außerdem empfängt sie das Ausgangssignal der Diodenmatrix 29 über die Videoleitung 41. Struktur und Wirkungswise geeigneter Steuervorrichtungen 31 zur Aufnahme und Verarbeitung der Diodenmatrix-Signale und das Verfahren zur Bestimmung des Abstands der Kanten ist genau in der US- Patentschrift 3 957 376 beschrieben. Zu den Steuervorrichtungen gehört ein Rechner 32, beispielsweise das Modell IBM 360/30, mit dem die Lage benachbarter Nullstellen im Beugungsmuster bestimmt wird. Der laterale Abstand zwischen den Linienkanten ergibt sich aus der Formel:

$$\text{Abstand zwischen Linienkanten} = \frac{2 \times \text{Lichtwellenlänge} \times (\text{effektive Brennweite}) \times (\text{Nummer der spezifischen Minima})}{\text{Abstand zwischen symmetrischen Nullpunkten}}$$

In vorstehender Formel wird der Ausdruck "Nummer der spezifischen Minima" dadurch bestimmt, welche der symmetrischen Nullstellen der Intensität benutzt werden, d. h. durch die Art der verwendeten Nullstellen.

Wenn also die Nullstellen der Intensität 49 und 50 in Fig. 2 verwendet werden, ist die Nummer der spezifischen Minima gleich Eins. Wenn die nächstbenachbarten Nullstellen der Intensität verwendet werden, ist die Nummer der spezifischen Minima gleich Zwei.

Die Erfindung hat viele Anwendungsgebiete und kann, wie im folgenden beschrieben, dazu benutzt werden, Gegenstände aufeinander auszurichten, indem der laterale Abstand der jeweiligen Linienkanten an jedem Gegenstand bestimmmt wird und dann die Gegenstände so gegeneinander verschoben werden, bis der laterale Abstand einen Wert erreicht, der die erfolgte Ausrichtung anzeigt; ein Beispiel hierfür ist die Ausrichtung einer Belichtungsmaske bezüglich schon vorhandener Muster auf einer Halbleiterscheibe. Der laterale Abstand entsprechender Punkte auf zwei Gegenständen kann auf die gleiche Weise bestimmt werden, beispielsweise beim Vergleich der Muster verschiedener, übereinandergelegter Masken eines Maskensatzes, der zur Herstellung integrierter Schaltungen verwendet wird.

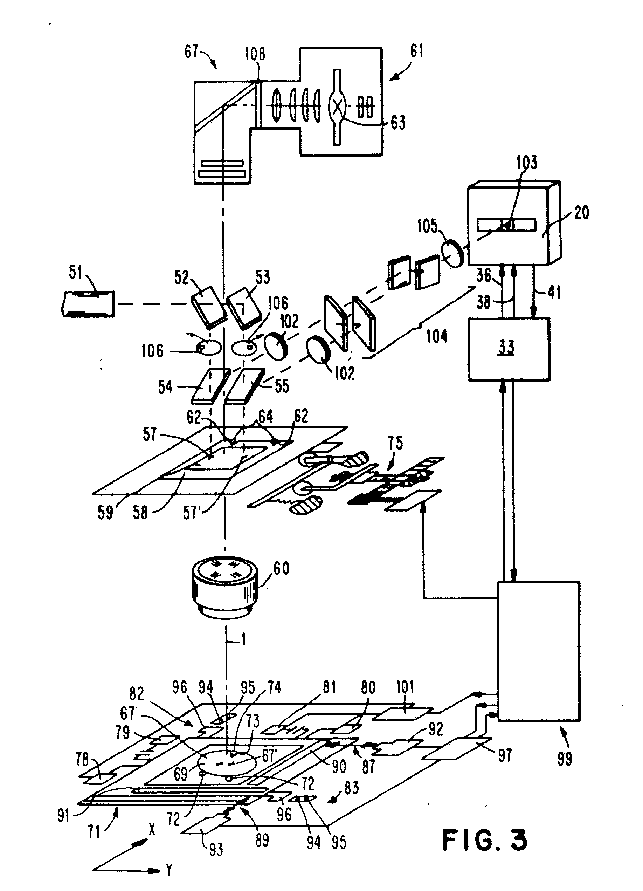

Fig. 3 zeigt ein System zum Ausrichten einer Belichtungsmaske gegenüber Mustern einer strahlungsempfindlichen Schicht auf einer Halbleiterscheibe. Lichtquelle 51 liefert kollimiertes, monochromatisches, räumlich kohärentes Licht, das auf einen Strahlteiler 52 und einen Spiegel 53 fällt. Als Lichtquelle 51 kann ein Helium-Cadmiumlaser mit einer Ausgangsleistung von 15 mW dienen, beispielsweise ein Modell der Firma Spectraphysics. Eine Helium-Cadmiumlichtquelle ist nämlich kompatibel mit der im Blauen und im Violetten korrigierten Linse 60 des Projektionsbelichtungsverfahrens zur Belichtung des Photolacks. Dadurch entfällt die Notwendigkeit für eine Korrekturlinse, wenn einerseits die Ausrichtung mit Hilfe des Laserlichts erfolgt und andererseits die Belichtung des Photolacks mit der Lichtquelle 61. Lichtquelle 61 umfaßt eine Quecksilberlampe 63, eine Kondersorlinse und eine Spiegelanordnung 67.

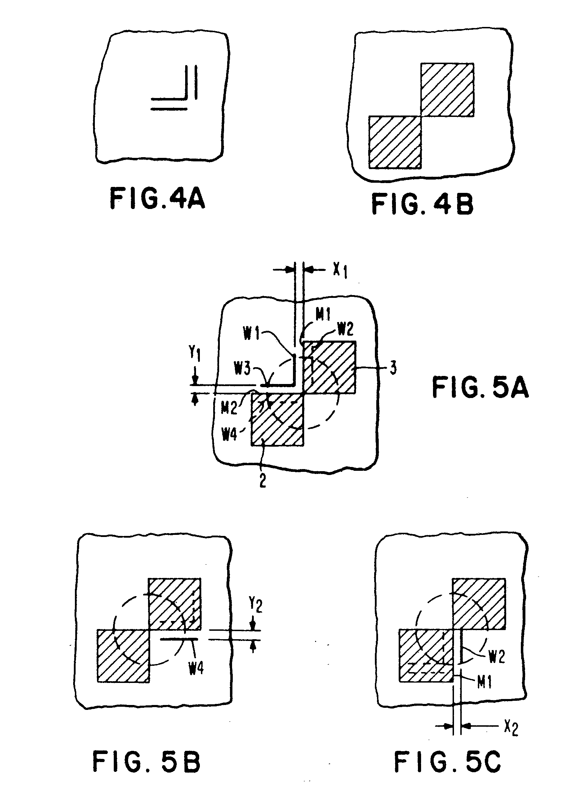

Das vom Strahlteiler 52 und vom Spiegel 53 reflektierte Licht durchläuft die Strahlteiler 54 bzw. 55 und bildet einen Lichtfleck mit 0,16 mm Durchmesser zur Beleuchung der Richtmarken 57 und 57' auf Maske 59 under der entsprechenden Marken 67 und 67' auf der mit Photolack überzogenen Halbleiterscheibe 69, die auf einem X—Y Tisch 71 angeordnet ist. Mit Verschlußblenden 106 können die Richtmarken auf der linken und der rechten Seite abwechselnd beleuchtet werden. Maske 59 ist in einem Rahmen 58 enthalten, dessen Kerben 62 mit Stift 64 in Übereinstimmung gebracht werden. Halbleiterscheibe 69 wird auf Tisch 71 durch Finger 72 in der richtigen Lage gehalten; die Finger drücken die Kerbe 73 in der Halbleiterscheibe gegen Stift 74. Ein Drehsystem 75 für die Maske erlaubt deren Winkelausrichtung bezüglich der Scheibe 69 durch Drehung un eine (nicht dargestellte) Achse. Die Achse kann dabei innerhalb oder an der Seite der Maske liegen. Die Rotationsachse verläuft im dargestellten Ausführungsbeispiel durch das Maskenzentrum auf einer Linie, auf der die Mittelpunkte der beiden Marken liegen. Der X—Y Tisch 71 kann in den zueinander orthogonalen X- und Y-Richtungen durch die Schrittmotoren 78, 79, 80 und 81 bewegt werden. Ein Paar von Motoren, einer für die Grobeinstellung und einer für die Feineinstellung des Tisches 71, ist für jede Richtung vorgesehen. Tisch 71 weist Sensoren 82 und 83 für die Beuzgspositionen der X- bzw. Y-Richtung auf, um das Tischzentrum in die mit der optischen Achse 1 übereinstimmende Bezugsposition der Koordinaten (0,0) zu bringen. Zu den Sensoren 82 und 83 gehört jeweils ein Paar in Tandemanordnung montierten optoelektronischen Bildwandlern 94 und 95. An den Seiten des Tisches 71 sind Fahnen 96 angebracht, die in gleicher Richtung wie die optoelektronischen Wandler verlaufen und deren Breite so ausgewählt ist, daß sie beide die auf die optoelektronischen Wandler fallenden Lichtstrahlen gleichzeitig dann und nur dann, unterbrechen, wenn der Tisch die richtige X- oder Y-Bezugsposition aufweist. Die Laserinterferometer 87 und 89 messen die Bewegung und damit auch die Lage des Tisches 71 in X- und Y-Richtung; diese Interferometer sind im Stand der Technik bekannt und umfassen ein Paar von Dachprismen 90 und 91, die auf Tisch 71 mit den zugehörigen Lasern 92 und 93 montiert sind. Zu den Laserinterferometern gehören zugeordnete Zähler 97, mit denen die Tischbewegung aufgezeichnet und an eine Systemsteuereinheit 99 gegeben wird, die ihrerseits beispielsweise einen Rechner des Modells IBM Model 360/30 umfaßt. Das Steuersystem 99 beaufschlagt die Motoren 78, 79, 80 und 81 über den Grob- und Feineinstellungsselektor 101 zur Bewegung des Tisches über die gewünschte Distanz in X- und Y-Richtung. Die Anordnung der Interferometer und die Motorsteurung sind bekannt und beispielsweise genauer in der US- Patentschrift 4 052 603 beschrieben, auf die hier Bezug genommen wird. Der X—Y Tisch wird von der Systemsteuerung 99 so verschoben, daß die Richtmarken 67 und 67' in eine Lage kommen, in der sie von den zur Ausrichtung benutzten Lichtbüdeln getroffen werden. Die Richtmarken 67 und 67' umfassen Linienkanten, die auf übliche Art und Weise in das Halbleiterplättchen eingeätzt sind, wobei mindestens eine Kante in jeder Marke für die beiden zueinander orthogonalen X- und Y-Richtungen vorgesehen ist. Entsprechende Richtmarken 57 und 57', die auch jeweils mindestens eine Linienkante in X- und Y-Richtung aufweisen, befinden sich auf Maske 59. Für die Richtmarken gibt es mehrere geeignete Konfigurationen. Ein Beispiel ist in den Fign. 4a und 4b dargestellt; in Fig. 4a ist ein Richtmarker-Muster für eine Halbleiterscheibe mit Paaren paralleler Linienkanten in X- und Y-Richtung wiedergegeben, Fig. 4b zeigt eine geeignete Richtmarke mit einem Paar undurchsichtiger Quadrate, die beispielsweise aus Chrom bestehen.

Die Beugungsmuster, die von einander entsprechenden Linienkanten der Maskenrichtmarken 57 und 57' und dem von der Linse 60 in der Ebene der Maske 59 erzeugten Bild der Linienkanten der Marken 67 und 67' hervorgerufen werden, gelangen über die Strahlteiler 54 und 55, die Linsen 102 (beispielsweise photographische Linse Nikon 55 mm), das Spiegelsystem 104 und die Linse 105 (beispielsweise 3,2·Leitzmitroskop-Objektiv) zur Diodenmatrix 103 des Sensors 20; bei letzterem kann es sich beispielsweise um einen Festkörper-Linienabtaster der Reticon Corporation (Modell RL-256-DA) handeln, bei dem Siliciumphotodioden 56 mit Abständen von 25 u angeordnet sind. Die Beugungsmuster oder die Diodenmatrix können auf bekannte Art um 90° gedreht werden, um somit die von den Linienkanten in X- oder Y-Richtung erzeugten Muster abzutasten. In einer Alternativen Ausführungsform können auch zwei Reihen von Photoelementen in orthogonaler Anordnung für X- bzw. Y-Richtung vorgesehen sein. Die zugehörigen Steuereinrichtungen 33 entsprechen den für das Ausführungsbeispiel nach Fig. 1 beschriebenen mit der Ausnahme, daß bei dieser Ausführungsform der Rechner ein Teil der Steuereinrichtung 99 für das gesamte System ist. Der Abstand einander entsprechender Linienkanten wird aus der Lage Minima im Beugungsmuster bestimmt, das von der Diodenmatrix 103 abgetastet wird. Die Systemsteuerung 99 steuert dann die Bewegung der Maske 59 und der Halbleiterscheibe 69, um den Abstand zwischen entsprechenden Kantenpaaren der Richtmarken einzustellen und damit die Muster auf der Maske und der Halbleiterscheibe gegeneinander für den Belichtungsvorgang des Photolacks auszurichten. Das Belichten erfolgt durch Schließen der Verschlußblende 106 und Öffnen der Blende 108; dadurch fällt Licht aus der Quecksilberlampe 63 auf die Maske, die dann mit Linse 60 auf die Oberfläche der mit Photolack überzogenen Halbleiterscheibe fällt und den Photolack entsprechend der Maske belichtet. Der Photolack wird anschließend entwickelt, um das Reliefmuster aus Photolack auf der Halbleiterscheibe zu erzeugen.

Beim Betrieb wird die Halbleiterscheibe mit Richtmarken 67 und 67' nach der Darstellung in Fig. 4a und die Maske mit Richtmarken 57 und 57' entsprechend der Darstellung in Fig. 4b versehen, dann wird entsprechend Fig. 3 die Maske 59 in den Maskenhalter und die Halbleiterscheibe 69 auf den X—Y Tisch gelegt. Das Verfahren zur gegenseitigen Ausrichtung erfolgt dann entsprechend der Darstellung in den Fign. 5a, 5b und 5c. Der X—Y Tisch wird um einen vorher bestimmten Betrag aus der Bezugsposition (0,0) herausgefahren, um die Richtmarken der Halbleiterscheibe in den Bereich der Lichtstrahlen des Ausrichtsystems zu bringen; die Maske wird dann so eingerichtet, daß die Abstände von Kante zu Kante den Nominalwert für das Ausrichten besitzen. Die Tischposition in X- und Y-Richtung wird mit Hilfe des Interferometersystems festgestellt. Die linke Verschlußblende 106 ist so eingestellt, daß der Beleuchtungsstrahl für die links liegenden Richtmarken unterbrochen wird; die rechte Verschlußblende wird geöffnet und so der Beleuchtungsstrahl für die rechts liegenden Richtmarken durchgelassen. Der Satz Richtmarken auf der rechten Seite wird dann gemäß Fig. 5a eingestellt. Der gestrichelt gezeichnete Kreis in Fig. 5a bezeichnet den Beleuchtungsfleck, die Bilder W2 und W4 der Kanten des Halbleiterplättchens sind gestrichelt gezeichnet, da sie von den lichtundurchlässige Quadraten 2 und 3 der Maskenrichtmarke abgedeckt werden. Die Lücke ($X_1$) zwischen dem Bild $W_1$ der Kante auf der Halbleiterscheibe und der Kante $M_1$ der Maske wird dann aus der Lage der Minima im Beugungsbild bestimmt. In ähnlicher Weise wird die Lücke ($Y_1$) zwischen dem Bild $W_3$ der Kante der Halbleiterscheibe und der Kante $M_2$ der Maske aus der Minima des Beugungsbildes bestimmt. Der X—Y Tisch wird dann um einen bestimmten Betrag in X-Richtung nach rechts verschoben und seine Stellung mit dem Laserinterferometer bestimmt; die Richtmarken haben dann die in Fig. 5b dargestellte Lage. Die Lücke ($Y_2$) zwischen dem Bild $W_4$ der Kante auf der Halbleiterscheibe und der Kante $M_2$ der Maske wird dann auf Grund der Minima des Beugungsbildes bestimmt.

Die Marken in Y-Richtung sind gegeneinander ausgerichtet, wenn $Y_1$ und $Y_2$ gleich sind. Die korrekte Lücke auf jeder Seite der Kante $M_2$ ist daher gleich den gemessenen Werten $Y_1$ plus $Y_2$ dividiert durch zwei. Der Unterschied zwischen den gemessenen Werten der Lücke und der korrekten Lücke ist dann bekannt und die genaue Tischposition für die Ausrichtung in Y-Richtung an der rechten Richtmarke kann berechnet werden. Der Tisch wird dann in X- und Y-Richtung um einen vorgewählten Betrag nach unten und nach links verschoben, so daß die Richtmarken die in Fig. 5c gezeigte Lage einnehmen; die Tischposition wird wieder mit dem Laserinterferometer gemessen. Die Lücke $X_2$ zwischen dem Bild $W_2$ der Kante auf der Halbleiterscheibe und der Kante $M_2$ der Maske wird aus der Lage der Minima im Beugungsbild bestimmt. Unter der Annahme, daß der Marke in X-Richtung ausgerichtet ist, wenn $X_1$ und $X_2$ gleich sind, ergibt sich die korrekte Lücke als (gemessene Werte $X_1$ plus $X_2$ dividiert durch zwei). Dabei ist angenommen, daß der Tisch wieder in die ursprüngliche X-Position zurückgeführt wurde, entsprechend der Darstellung in Fig. 5a; wenn nicht, müssen die Werte gemäB der vom Interferometer gemessenen Verschiebung in X-Richtung korrigiert werden. Der Unterschied zwischen den gemessenen Abständen und dem richtigen Abstand ist dann bekannt, so daß die richtige Tischposition für die X-Ausrichtung der Richtmarken auf der rechten Seite berechnet werden kann. Die berechneten Werte für die X- und Y-Ausrichtung für die rechte Seite, die mit $X_R$ und $R_R$ bezeichnet werden, sind somit bekannt. Betragen die Abstände bei erfolgter Ausrichtung der Marken 200 $\mu$ und beträgt der Abstand zwischen den linken und den rechten Marken auf der Maske ungefähr 5 cm, so beträgt die größte auftretende Fehlausrichtung in axialer Richtung ($\theta$), die korrigiert werden muß, $2 \cdot 10^{-4}$ Rad. Bei diesem maximal möglichen Fehler erfolgt die Ausrichtung in axialer Richtung folgendermaßen: Der X—Y Tisch wird so verschoben, daß der Mittelpunkt der rechten Marken bei $X_R$, $Y_R$ liegt, d. h. $\Delta Y_R = \Delta X_R = 0$. Die Verschlußblenden 106 werden dann so verschoben, daß der Strahl für die rechten Marken unterbrochen ist, der Strahl für die linken Marken dagegen durchkommt. Der Unterschied $\Delta Y_L$ zwischen den Abständen in Y-Richtung des linken Markensatzes wird dann durch Analyse der Beugungsmuster mit Hilfe der gleichen Schritte bestimmt, mit denen die Y-Abstände auf der rechten Seit entsprechend der obigen Beschreibung und den Fign. 5a und 5b ermittelt wurden.

Der gemessene Unterschied $\Delta Y_L$, entspricht dann einem Winkel $(\Delta Y_L)^\circ$. Zum Korrigieren dieser Fehlausrichtung ist eine Bewegung um $(\Delta Y_L)^\circ/2$ der rechten Marken mit Mittelpunkt bei $\Delta Y_R = \Delta Y_R = 0$ erforderlich. Dies erfolgt zur Hälfte durch Rotation und zur Hälfte durch Translation in folgender Weise. Die Maske wird um den Winkel

$$\theta = \frac{(\Delta Y_L)^\circ/4}{d2} = \frac{(\Delta Y_L)^\circ}{2d}$$

gedreht (d ist der Abstand zwischen den Richtmarken), durch den $\Delta Y_L$ zur Hälfte auf Null gebracht wird, d. h. auf

$$\frac{(\Delta Y_L)^\circ}{2};$$

dadurch wird aber auch $\Delta Y_R$ von Null auf den Wert

$$\theta \times d = \frac{(\Delta Y_L)^\circ}{2}$$

gebracht, so daß sowohl die linke als auch die rechte Seite um den Betrag

$$\frac{(\Delta Y_L)^\circ}{2}$$

in gleicher Richtung verschoben sind. Die Ausrichtung erfolgt dann durch Verschieben des X—Y Tisches um diesen Betrag in Y-Richtung. Bei dem kleinen erforderlich Drehwinkel ist eine Korrektur in X-Richtung auf der linken infolge der Maskendrehung nicht erforderlich, wenn $\Delta X_R$ schon auf den Wert Null gesetzt wurde.

Für das Ausrichten können auch viele andere Muster und Verfahren verwendet werden. Beispielsweise könnte in dem geschilderten Ausführungsbeispiel der Abstand der Linien der Richtmarken auf der Halbleiterscheibe zuerst mit Hilfe der Analyse von Beugungsfiguren gemessen werden, so daß nach Durchführung der Messungen in Fig. 5a der Abstand von der Mittelposition der Maskenlinien gleich dem Unterschied zwischen der Messung des Kantenabstands und der Hälfte des gemessenen Abstands zwischen den Richtmarkenlinien auf der Halbleiterscheibe wäre.

Die Achse für die Maskendrehung braucht nicht durch die Mittelpunktslinie zwischen den Richtmarken zu verlaufen; die Kenntnis ihrer Lage genügt, da dann der Algorithmus für das Ausrichten entsprechend der Lage des Drehpunktes modifiziert werden kann. Es ist auch nicht erforderlich, daß beim Hin- und Herbewegen zwischen den linken und rechten Richtmarken kontinuierlich gemessen wird. Jeder der Gegenstände kann zur Ausrichtung verschoben werden. Wenn Linse 60 eine Verkleinerung des Bildes liefert, sind Lagefehler der Maske mit ihrem größeren Muster weniger wichtig, so daß bei der Verschiebung der Maske zur genauen Ausrichtung weniger genaue Messungen erforderlich sind, als bei Verschiebung der Halbleiterscheibe.

Die Erfindung kann nicht nur zur gegenseitigen Ausrichtung von Gegenständen verwendet werden, sondern auch zer bestimmung des Abstands von Linienkanten auf zwei Gegenständen. Beispielsweise kann die Überlappung von Mustern auf zwei Gegenständen dadurch gemessen werden, daß die Überlappungen an verschiedenen Punkten der Muster gemessen werden. Dies ist beispielsweise erforderlich, wenn eine Reihe von Masken für verschiedene Herstellungsstufen von integrierten Schaltkreisen mit einer Schrittkamera erzeugt werden, die einzelne Abschnitte nebeneinander abbildet. Wenn die Lage der einzelnen wiederholten Musterabschnitte von Maske zu Maske verschieden ist, so treten selbst bei genauer Ausrichtung der Masken Fehler bei der Ausrichtung der Muster innerhalb der Masken und der Muster auf der Halbleiterscheibe auf, die über den zulässigen Toleranzen für die Herstellung von integrierten Schaltkreisen liegen. Sätze von Masken können daher bezüglich der vorgeschriebenen Überlappung mit Hilfe der Erfindung geprüft werden um sicherzustellen, daß mit ihnen integrierte Schaltungen mit guter Ausbeute hergestellt werden können.

Das Bild des Musters auf der Halbleiterscheibe am Ort der Maske kann mit optischen Systemen erzeugt werden, die spiegelnde oder brechende Elemente verwenden. Wenn zwei durchsichtige Gegenstände, wie beispielsweise Masken, vorliegen, kann die Messung auch hinter dem zweiten Gegenstand mit dem Beugungsbild erfolgen, das vom Bild der auf dem ersten Gegenstand gelegenen Kante in der Ebene des zweiten Gegenstands gebildet wird.

**Patentansprüche**

1. Einrichtung zur optischen Messung des lateralen Abstands zwischen linear ausgedehnten, im wesentlichen parallelen Bereichen (Linien oder Kanten 11, 15) zweier Gegenstände (13, 17), die nicht in der gleichen optischen Ebene liegen und mit kollimiertem, monochromatischem, räumlich kohärentem Licht beleuchtet werden, um in einer Auswertebene (20) ein Interferenzbild (30) zu erzeugen, dadurch gekennzeichnet, daß eine Abbildungseinrichtung (19) ein in der optischen Ebene der Linie (15) des ersten Gegenstands (17) liegendes, reelles Bild (21) der Linie (11) des zweiten Gegenstands (13) erzeugt und daß das Licht der Linie (15) des ersten Gegenstands zusammen mit dem Licht des Bildes (21) der Linie (11) des zweiten Gegenstands (13) zur Interferenz gebracht wird.

2. Einrichtung nach Anspruch 1, dadurch gekennzeichnet, daß der erste Gegenstand (17) durchsichtig, der zweite Gegenstand (13) undurchsichtig ist, daß die Abbildung der Kante (11) des zweiten Gegenstandes (13) mit reflektiertem Licht erfolgt und daß durch Abbildungseinrichtungen (27, 28), die auf der dem zweiten Gegenstand (13) entgegengesetzten Seite des ersten Gegenstandes (17) liegen, das Beugungsbild (30) auf einem Photoempfänger (29) abgebildet wird.

3. Einrichtung nach Anspruch 1 oder 2, dadurch gekennzeichnet, daß das Beugungsbild (30) auf eine Mehrzahl photoempfindlicher Elemente (29) mit linienförmiger oder matrixförmiger Anordnung abgebildet wird.

4. Einrichtung nach Anspruch 3, dadurch gekennzeichnet, daß die Bestimmung der Intensitätsminima des Beugungsbilds (30) durch einen Rechner (32) erfolgt.

5. Einrichtung nach einem der Ansprüche 1 bis 4, dadurch gekennzeichnet, daß die zu messenden Linien in X- und Y-Richtung verlaufende Kanten von Richtmarken sind, die auf gegeneinander auszurichtenden Gegenständen angebracht sind.

6. Einrichtung nach Anspruch 5, dadurch gekennzeichnet, daß die Einrichtung Bestandteil eines Maskenbelichtungssystems für Halbleiterscheiben ist, daß die Abbildungseinrichtung für die Linie des zweiten Gegenstands (Halbleiterscheibe 69) in der optischen Achse des Belichtungssystems angeordnet ist, und daß die Richtmarken (57, 57' bzw. 67, 67'; Fig. 3) auf der Belichtungsmaske (59) bzw. der Halbleiterscheibe (69) angeordnet sind.

7. Einrichtung nach Anspruch 6, dadurch gekennzeichnet daß die Richtmarken aus zwei gleichen Einzelmarken bestehen, die in einem großen Abstand voneinander angeordnet sind, daß die Richtmarken der Belichtungsmaske jeweils aus zwei Paaren paralleler Striche bestehen, die rechtwinklig zueinander verlaufen (Fig. 4A) und daß die Richtmarken der Halbleiterscheibe aus zwei undurchsichtigen Quadraten bestehen, die in einer Spitze zusammenstoßen (Fig. 4B).

8. Einrichtung nach Anspruch 7, dadurch gekennzeichnet, daß Blenden (106) zur wahlweisen Beleuchtung einer der Richtmarken auf Belichtungsmaske und Halbleiterscheibe vorgesehen sind.

9. Einrichtung nach Anspruch 6 oder 7, dadurch gekennzeichnet, daß die Wellenlänge der monochromatischen, räumlich kohärenten Lichtquelle (51) im Spektralbereich der Lichtquelle (63) zur Belichtung der Halbleiterscheibe liegt.

10. Einrichtung nach einem der Ansprüche 6 bis 9, dadurch gekennzeichnet, daß zur gegenseitigen Ausrichtung von Belichtungsmaske (59) und Halbleiterscheibe (69) der Rechner (33) zur Auswertung des Beugungsbildes Steuersignale an ein Steuersystem (99) gibt, das Stellglieder (75, 78 bis 81) zur Verschiebung von Belichtungsmaske und/oder Halbleiterscheibe steuert.

**Claims**

1. Device for optically measuring the lateral spacing between linearly extending, substantially parallel regions (lines or edges 11, 15) of two objects (13, 17) not in the same optical plane, and illuminated with collimated, monochromatic, spatially coherent light in order to generate an interference image (30) in an evaluation plane (20), characterized in that an imaging device (19) generates a real image (21) of the line (11) of the second object (13), which image is in the optical plane of the line (15) of the first object (17), and in that the light of the line (15) of the first object is made to interfere with the light of the image (21) of the line (11) of the second object (13).

2. Device as claimed in claim 1, characterized in that the first object (17) is transparent and the second object (13) is opaque, that the edge (11) of the second object (13) is imaged with reflected light, and that by imaging means (27, 28) provided on that side of the first object (17) which is opposite to the second object (13) the diffraction image (30) is imaged on a photo receiver (29).

3. Device as claimed in claim 1 or 2, characterized in that the diffraction image (30) is imaged onto a plurality of photosensitive elements (29) with linear or matrix-shaped arrangement.

4. Device as claimed in claim 3, characterized in that the intensity minima of the diffraction image (30) are determined by a computer (32).

5. Device as claimed in one of claims 1—4, characterized in that the lines to be measured are edges in X and Y direction of alignment marks applied on objects to be aligned with respect to each other.

6. Device as claimed in claim 5, characterized in that the device is part of a mask exposure system for semiconductor wafers, that the imaging device for the line of the second object (semiconductor wafer 69) is arranged in the optical axis of the exposure system, and that the alignment marks (57, 57' and 67, 67'; Fig. 3) are arranged on the exposure mask (59) and on the semiconductor wafer (69).

7. Device as claimed in claim 6, characterized in that the alignment marks consist of two equal individual marks arranged at a great distance from each other, that the alignment marks of the exposure mask each consist of two pairs of aparallel lines extending rectangularly to each other (Fig. 4A), and that those of the semiconductor wafer consist of two opaque squares meeting in a point (Fig. 4B).

8. Device as claimed in claim 7, characterized in that shutters (106) are provided for the selective illumination of one of the alignment marks on exposure mask and semiconductor wafer.

9. Device as claimed in claim 6 or 7, characterized in that the wave length of the monochromatic, spatially coherent light source (51) is in the spectral range of the light source (63) for the exposure of the semiconductor wafer.

10. Device as claimed in one of claims 6—9, characterized in that for the mutual alignment of exposure mask (59) and semiconductor wafer (69) the computer (63) for the evaluation of the diffraction image supplies control signals to a control system (99) controlling adjustment units (75, 78—81) for displacing exposure mask and/or semiconductor wafer.

**Revendications**

1. Dispositif pour la mesure optique de l'espacement latéral entre des régions s'étendant linéairement et étant essentiellement parallèles (lignes ou bords 11, 15) de deux objets (13, 17) qui ne se trouvent pas dans le même plan optique et qui sont illuminés par une lumière collimatée, monochromatique et spatialement cohérente afin de produire une image d'interférence (30) dans un plan d'évaluation (20), caractérisé en ce qu'un dispositif de reproduction (19) produit une image réelle (21) du la ligne (11) du second objet (13), cette image étant dans le plan optique de la ligne (15) du premier objet (17), et en ce que la lumière de la ligne (15) de premier objet est amené en interférence avec la lumière de l'image (21) de la ligne (11) du second objet (13).

2. Dispositif selon la revendication 1, caractérisé en ce que le premier objet (17) est transparent, et que le second objet (13) est opaque, en ce que la reproduction du bord (11) du second objet (13) utilise de la lumière réfléchie, et en ce que des dispositifs de reproduction (27, 28) se trouvant du côté du premier objet (17) qui est opposé au second objet (13) reproduisent l'image de diffraction (30) sur un photorécepteur (29).

3. Dispositif selon la revendication 1 ou 2, caractérisé en ce que l'image de diffraction (30) est reproduite sur une pluralité d'éléments photosensibles (29) dans un arrangement formé par des lignes ou des matrices.

4. Dispositif selon la revendication 3, caractérisé en ce · que les valeurs minimales d'intensité de l'image de diffraction 30 sont déterminées par un ordinateur (32).

5. Dispositif selon l'une quelconque des revendications 1 à 4, caractérisé en ce que les lignes à mesurer sont constituées par des bords de marques d'alignement dans les directions X et Y, ces marques étant disposées sur des objets à aligner les uns par rapport aux autres.

6. Dispositif selon la revendication 5, caractérisé en ce que le dispositif est une partie d'un système d'exposition de masques pour des tranches semi-conductrices, en ce que le dispositif de reproduction pour la ligne du second objet (tranche semi-conductrice 69) est disposé dans l'axe optique du système d'exposition, et en ce que les marques d'alignement (57, 57' et 67, 67'; figure 3) sont disposées sur le masque d'exposition (59) et la tranche semi-conductrice (69) respectivement.

7. Dispositif selon la revendication 6, caractérisé en ce que les marques d'alignement sont composées de deux marques semblables très espacées l'une de l'autre, en ce que les marques d'alignement du masque d'exposition sont composées chacune de deux paires de traits parallèles disposés à angle droit (figure 4A), et en ce que les marques d'alignement de la tranche semi-conductrice sont composées de deux carrés opaques qui se touchent en un point (figure 4D).

8. Dispositif selon la revendication 7, caractérisé en ce qu'il comporte des diaphragmes (106) pour illuminer sélectivement l'une des marques d'alignement sur le masque d'exposition et la tranche semi-conductrice.

9. Dispositif selon la revendication 6 ou 7, caractérisé en ce que le longueur d'onde de la source de lumière monochromatique et spatialement cohérente (51) se situe dans la gamme de spectre de la source de lumière (63) pour exposer la tranche semi-conductrice.

10. Dispositif selon l'une quelconque des revendications 6 à 9, caractérisé en ce que, pour l'alignement du masque d'exposition (59) sur la tranche semi-conductrice (69), l'ordinateur (33) transmet des signaux de commande à un système de commande (99) pour évaluer l'image de diffraction, le système de commande commandant des éléments de positionnement (75, 78 à 81) pour décaler le masque d'exposition et/ou la tranche semi-conductrice.

FIG. 1

EBENE DES BEUGUNGSBILDES

FIG. 2

FIG. 3

FIG.4A
FIG. 4B

FIG. 5A

FIG. 5B
FIG. 5C